# EUROPÄISCHE PATENTSCHRIFT

(11) **EP 0 426 900 B1**
(45) Veröffentlichungstag und Bekanntmachung des Hinweises auf die Patenterteilung: **13.09.1995**
(21) Anmeldenummer: 89120906.6
(22) Anmeldetag: 10.11.1989
(51) Int. Cl.: H03B 5/12

(54) **Integrierbare frequenzvariable Oszillatorschaltung**
Frequency variable oscillator circuit, suitable for integration
Circuit oscillateur à fréquence variable, pouvant être intégré

(43) Veröffentlichungstag der Anmeldung: 15.05.1991
(73) Patentinhaber: SIEMENS AKTIENGESELLSCHAFT, 80333 München (DE)
(72) Erfinder: Fenk, Josef, Dipl.-Ing., D-8057 Eching/Ottenburg (DE); Schulz, Martin, Dipl.-Ing., D-5013 Elsdorf-Berrendorf (DE)

(56) Entgegenhaltungen:
- DE-A- 2 131 159
- DE-A- 2 649 745
- US-A- 3 815 052
- US-A- 4 595 887
- US-A- 4 761 616

## Beschreibung

Die Erfindung betrifft eine integrierbare frequenzvariable Oszillatorschaltung mit einer rückgekoppelten Verstärkeranordnung mit den Merkmalen:
a) ein frequenzbestimmendes Rückkopplungsglied ist zwischen zwei Eingangsklemmen geschaltet,
b) die erste Eingangsklemme ist mit je einem Eingang zweier Verstärkerstufen verbunden,
c) die Verstärkerstufen erzeugen jeweils Ausgangssignale,
d) die Verstärkung der zweiten Verstärkerstufe ist veränderbar,
e) das Ausgangssignal der zweiten Verstärkerstufe wird einer phasenschiebenden Komponente zugeführt,
f) das Ausgangssignal der ersten Verstärkerstufe und das Ausgangssignal der zweiten Verstärkerstufe werden nach der phasenschiebenden Komponente aufaddiert und
g) über eine weitere phasenschiebende Komponente der zweiten Eingangsklemme zugeführt.

Eine Oszillatorschaltung ist zum Beispiel aus dem Datenblatt über den Baustein MC 1376 von Motorola Semiconductors bekannt. Der darin beschriebene Oszillator besteht aus einem Differenzverstärker, dessen Eingang mit dem ersten Anschluß eines frequenzbestimmenden Rückkopplungsglieds verbunden ist und in dessen ersten Ausgangszweig eine in der Verstärkung regelbare Verstärkerstufe geschaltet ist. Im zweiten Ausgangszweig des Differenzverstärkers ist ein Tiefpaß vorgesehen. Die Summe beider Ausgangssignale wird über eine weitere Verstärkerstufe dem zweiten Anschluß des frequenzbestimmenden Rückkopplungsglieds zugeführt. Durch die regelbare Verstärkung im ersten Ausgangszweig des Differenzverstärkers kann die Phase des Summensignals beider Ausgangszweige um maximal +45° gegenüber dem Eingangssignal des Differenzverstärkers und dementsprechend die Oszillatorfrequenz der Oszillatorschaltung variiert werden. Nachteile dieser Schaltungsanordnung sind, daß der regelbare Verstärker im Schwingkreis liegt und damit Rückwirkungen der Oszillatorfrequenz auf die Stellgröße möglich sind sowie daß der Phasendrehbereich auf 0...45° eingeschränkt ist.

In der US-Patentschrift 4 761 616 ist eine frequenzvariable Oszillatorschaltung beschrieben, die eine rückgekoppelte Verstärkeranordnung enthält. Die Verstärkeranordnung weist zwei parallel geschaltete Verstärkerzweige auf, die jeweils eine Verstärkerstufe mit veränderbarer Verstärkung enthalten. Einer der Zweige enthält außerdem einen Transistorverstärker zur Phasenverschiebung. Darüber hinaus kann in jedem Verstärkerzweig ein eine Phasenumkehr bewirkendes Element angeordnet werden. Verschiedene Phasenlagen des Ausgangssignals werden durch entsprechende Einstellung der in der Verstärkung veränderbaren Verstärker erzeugt. Die Frequenz der Oszillatorschaltung wird dadurch verändert. Als in der Verstärkung variable Verstärker werden bevorzugt PIN-Dioden verwendet.

In der deutschen Offenlegungsschrift 26 49 745 ist eine frequenzvariable Oszillatorschaltung mit einer Phasenverriegelungsschleife gezeigt. Diese umfaßt eine freilaufende Oszillatorschleife mit einem Verstärker, einem Additionskreis und einem Bandpaßfilter. Durch einen veränderbaren Phasenschieber wird das Ausgangssignal des Bandpaßfilters in den Additionskreis zurückgeführt. Ein Steuereingang des Phasenschiebers wird von einem Phasendetektor gesteuert, durch den eine Phasenabweichung des Oszillatorkreises von einer Vergleichsfrequenz festgestellt wird. Der variable Phasenschieber enthält einen Verstärker mit Amplitudensteuerung. Die Amplitudensteuerung wird durch eine entsprechende Aussteuerung der Transistoren von Differenzverstärkern bewirkt.

Die Aufgabe der Erfindung besteht darin, eine integrierbare frequenzvariable Oszillatorschaltung anzugeben, die möglichst verzerrungsfrei arbeitet.

Diese Aufgabe wird dadurch gelöst, daß
h) das Ausgangssignal der phasenschiebenden Komponente über eine dritte Verstärkerstufe geführt wird, i) die zweite Verstärkerstufe mindestens zwei Mehrfach-Emitter-Transistoren umfaßt,
j) von denen jeweils ein erster Teil der Emitter miteinander gekoppelt ist und von einem Strom einer ersten Stromstärke gespeist wird,
k) von denen jeweils ein zweiter Teil der Emitter von einem Strom einer zweiten Stromstärke gespeist wird,
l) und daß die Verstärkung durch den Unterschied zwischen den ersten und zweiten Stromstärken veränderbar ist.

Die Erfindung wird anhand von fünf Figuren näher erläutert. Es zeigen:
- Figur 1: eine erste Prinzipschaltungsanordnung für eine frequenzvariable Oszillatorschaltung,
- Figur 2: eine zweite Prinzipschaltungsanordnung für eine frequenzvariable Oszillatorschaltung,
- Figur 3: ein Zeigerdiagramm, das die Phasenbeziehung einiger Ströme und Spannungen der Prinzipschaltungsanordnungen wiedergibt,
- Figur 4: ein erstes erfindungsgemäßes Ausführungsbeispiel mit einem Serienschwingkreis gemäß der Prinzipschaltungsanordnung in Figur 1,
- Figur 5: ein zweites erfindungsgemäßes Ausführungsbeispiel mit einem Parallelschwingkreis gemäß der Prinzipschaltungsanordnung in Figur 2.

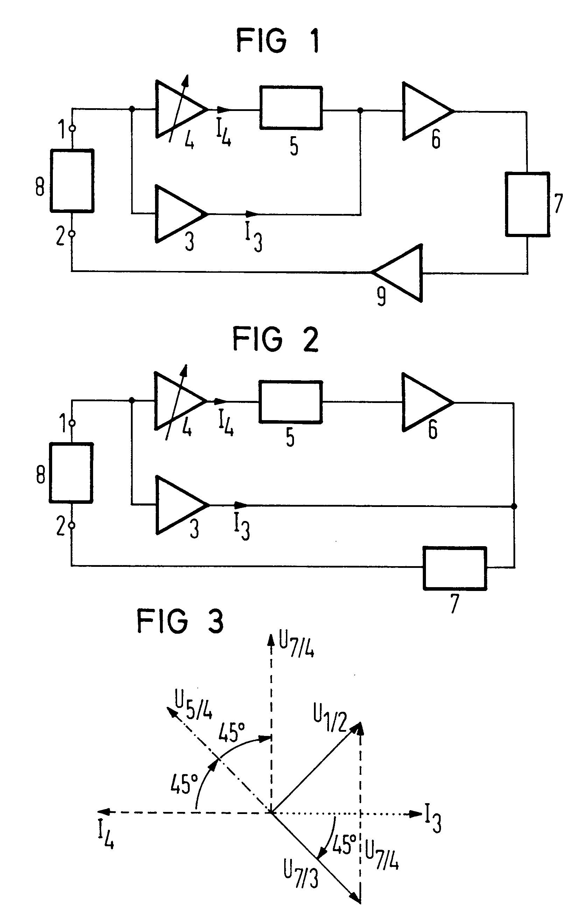

Die Anordnung nach Figur 1 hat zwei Anschlußklemmen 1, 2, zwischen denen ein frequenzbestimmendes Rückkopplungsglied, z.B. ein Schwingkreis, ein Quarz- oder ein Keramikschwinger, geschaltet ist. Die ersten Eingangsklemme 1 ist mit je einem Eingang einer von zwei Verstärkerstufen 3, 4 verbunden. Die Verstärkung der zwieten Verstärkerstufe 4 ist variabel. Der Ausgang der zweiten Verstärkerstufe 4 ist über eine phasenschiebende Komponente 5 mit dem Eingang einer dritten Verstärkerstufe 6 verbunden. Der Ausgang der ersten Verstärkerstufe 3 ist ebenfalls mit dem Eingang der dritten Verstärkerstufe 6 verbunden. Der Ausgang der dritten Verstärkerstufe 6 ist über eine weitere phasenschiebende Komponente 7 mit dem Eingang einer vierten Verstärkerstufe 9 verbunden. Der Ausgang der vierten Verstärkerstufe ist mit der zweiten Eingangsklemme verbunden.

In Verbindung mit Figur 3, die ein Zeigerdiagramm zeigt, welches die Phasenbeziehung nachfolgend genannter Spannungen und Ströme in der Prinzipschaltungsanordnung in Figur 1 darstellt, wird die Funktionsweise näher erläutert. Um einen möglichst großen Oszillationsfrequenzbereich bei gleichzeitig geringem Schaltungsaufwand zu erhalten, ist es vorteilhaft, daß die erste phasenschiebende Komponente 5 eine Phasenverschiebung von +225° und die zweite phasenschiebende Komponente 7 eine Phasenverschiebung von +45°, bei der durch das Rückkopplungsglied 8 bestimmten Resonanzfrequenz, bewirkt. Die Wahl dieser Phasenverschiebungen gewährleistet einen optimalen Oszillationsfrequenzbereich bei konstanter Ausgangsamplitude. Dies kann z.B. dadurch erreicht werden, daß die phasenschiebenden Komponenten 5, 7 durch Tiefpässe 1. Ordnung gebildet werden und die stromgesteuerte Verstärkerstufe 4 ein zur Verstärkerstufe 3 invertiertes Ausgangssignal erzeugt. Diese Realisierungsmöglichkeit sei nun für die folgende Funktionserläuterung angenommen.

Ist die Verstärkung der Verstärkerstufe 4 gleich Null, so ist der rückgekoppelte Verstärkerzweig, bestehend aus der Verstärkerstufe 4 und der nachfolgenden phasenschiebenden Komponente 5, ausgeschaltet. Die Oszillatorschaltung verhält sich dann wie eine normale rückgekoppelte Verstärkeranordnung. Durch die phasenschiebende Komponente 5 wird die Spannung U_{7/3} an der phasenschiebenden Komponente 7 gegenüber dem von der Verstärkerstufe 3 erzeugten Strom I₃ um +45° phasenverschoben. Die Schwingungsbedingung für eine rückgekopplete Verstärkeranordnung fordert, daß die Phase des rückgekoppelten Signals gleich Null oder ein ganzzahliges Vielfaches von π ist. Diese Schwingungsbedingung wird nur dann erfüllt, wenn sich eine entsprechende Oszillationsfrequenz einstellt.

Wird nun der durch die Verstärkerstufe 4 und die phasenschiebende Komponente 5 gebildete Verstärkerteilzweig durch eine Verstärkung, die größer Null ist, eingestellt, so stellt sich folgender Zustand ein: Die Verstärkerstufe 4 invertiert nun das Eingangssignal, und somit fließt an ihrem Ausgang ein zu I₃ um +180° phasenverschobener Ausgangsstrom I₄. Die Spannung U_{5/4} an der phasenschiebenden Komponente 5 ist gegenüber dem Strom I₄ um weitere +45° phasenverschoben. Über die Verstärkerstufe 6 und die phasenschiebende Komponente 7 verschiebt sich die Spannung U_{7/4} an der phasenschiebenden Komponente 7 um weitere +45°, also insgesamt um 90° gegenüber I₄.

Aus der Addition beider Spannungen U_{7/3} und U_{7/4} resultiert die an den Anschlußklemmen 1, 2 abgreifbare Spannung U_{1/2}. Die Phase der Spannung U_{1/2} und somit die entsprechende Frequenz der Oszillatorschaltung kann nun entsprechend der eingestellten Verstärkung der Verstärkerstufe 4 zwischen -45° und +45° gegenüber dem Strom I₃ variieren. Vorteilhafterweise kann das am Ausgang der phasenschiebenden Komponente 7 anliegende Signal über eine weitere Verstärkerstufe 9 ausgekoppelt werden. Diese Verstärkerstufe 9 kann aber bei entsprechender Dimensionierung der übrigen Schaltungsanordnung entfallen.

Ein weiterer Vorteil dieser Schaltungsanordnung ist, daß die bei den Eckfrequenzen, d. h. bei -45° und +45° Phasenverschiebung, um 3dB reduzierte Schwingkreisspannung durch die bei den Eckfrequenzen um 3dB größere Spannung des aktiven Schaltungsteils kompensiert wird.

FIG 2 zeigt eine zweite Prinzipschaltungsanordnung gemäß der Erfindung. Die Schaltungsanordnung entspricht weitesgehend der in FIG 1 gezeigten mit dem Unterschied, daß der Ausgang der ersten Verstärkerstufe 3 nicht mit dem Eingang der dritten Verstärkerstufe 6 verbunden ist, sondern daß das Ausgangssignal der ersten Verstärkerstufe 3 zwischen dem Ausgang der dritten Verstärkerstufe 6 und der phasenschiebenden Komponente 7 dem Ausgangssignal der dritten Verstärkerstufe 6 aufaddiert wird. Im übrigen entspricht die Funktionsweise der in FIG 2 gezeigten Prinzipschaltungsanordnung der in FIG 1 beschriebenen.

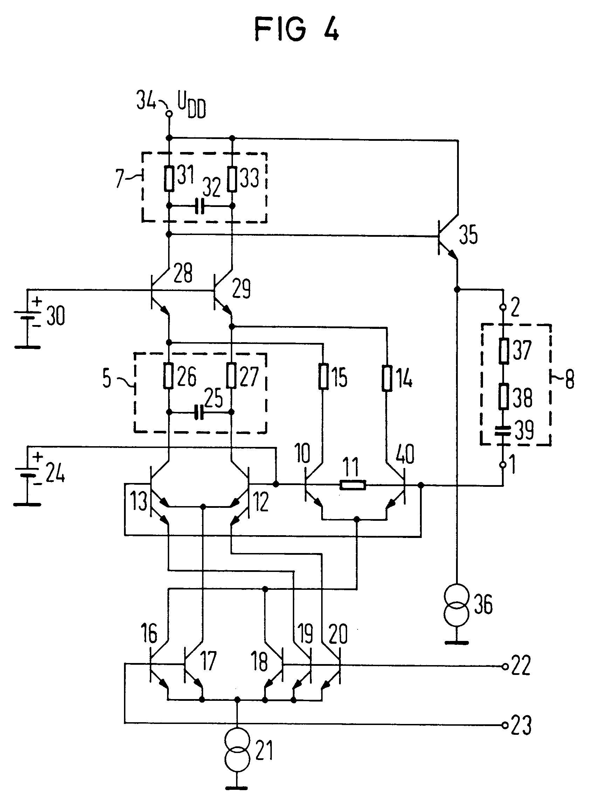

FIG 4 zeigt ein erstes Ausführungsbeispiel mit einem Serienschwingkreis gemäß der Prinzipschaltungsanordnung in FIG 1.

Der Serienschwingkreis, der zwischen die beiden Eingangsklemmen 1, 2 geschaltet ist, besteht aus einem Widerstand 37, einer Induktivität 38 und einem Kondensator 39. Die erste Verstärkerstufe 3 wird durch einen Differenzverstärker gebildet. Dieser besteht aus den Transistoren 40, 10, der Stromquelle 21 und den Transistoren 16, 18. Die Basis des ersten Transistors 40 ist mit der ersten Anschlußklemme 1 verbunden. An der Basis des zweiten Transistors 10 liegt eine Referenzspannung 24 an. Zwischen die Basis von Transistor 40 und Transistor 10 ist ein Widerstand 11 geschaltet. Die Emitter der Transistoren 40, 10 sind miteinander verbunden und über die Laststrecken zweier parallel geschalteter Transistoren 16, 18 mit dem ersten Anschluß der Stromquelle 21 verbunden. Der zweite Anschluß der Stromquelle 21 ist mit einem festen Potential, z.B. Masse verbunden. Die Basis des Transistors 18 ist mit einer ersten Eingangsklemme 22 verbunden und die Basis des Transistors 16 mit einer zweiten Eingangsklemme 23.

Die zweite stromgesteuerte Verstärkerstufe 4 wird ebenfalls durch einen weiteren Differenzverstärker gebildet. Dieser besteht aus zwei Mehrfach-Emitter-Transistoren 12, 13, der Stromquelle 21 und drei Steuertransistoren 17, 19, 20. Die Eingänge des zweiten Differenzverstärkers sind derart parallel zu den Eingängen des ersten Differenzverstärkers geschaltet, daß die Basis des Mehrfach-Emitter-Transistors 12 mit der Basis des Transistors 10 und die Basis des Mehrfach-Emitter-Transitors 13 mit der Basis des Transistors 40 verbunden ist. Die ersten Emitter der Mehrfach-Emitter-Transistoren 12 und 13 sind mit dem Kollektor des Transistors 17 verbunden. Der zweite Emitter des Mehrfach-Emitter-Transistors 12 ist mit dem Kollektor des Transistors 20 und der zweite Emitter des Mehrfach-Emitter-Transistors 13 mit dem Kollektor des Transistors 19 verbunden. Die Emitter der Transistoren 17, 19 und 20 sind mit dem ersten Anschluß der Stromquelle 21 verbunden. Die Basis des Transistors 17 ist mit der Basis des Transistors 16 und die Basis der Transistoren 19, 20 mit der Basis des Transistors 18 verbunden.

Die phasenschiebende Komponente 5 wird durch einen symmetrisch aufgebauten Tiefpaß gebildet. Dieser besteht aus zwei Widerständen 26, 27 und einem Kondensator 25. Der Kondensator 25 ist zwischen die Kollektoren der Mehrfach-Emitter-Transistoren 12, 13 geschaltet. Der erste Anschluß des Widerstands 26 ist mit dem Kollektor des Mehrfach-Emitter-Transistors 13 und der erste Anschluß des Widerstands 27 ist mit dem Kollektor des Mehrfach-Emitter-Transistors 12 verbunden. Der zweite Anschluß des Widerstands 26 ist über einen weiteren Widerstand 15 mit dem Kollektor des Transistors 10 verbunden. Der zweite Anschluß des Widerstands 27 ist über einen weiteren Widerstand 14 mit dem Kollektor des Transistors 9 verbunden. Die zweiten Anschlüsse der Widerstände 26, 27 sind außerdem mit jeweils einem Emitter zweier Transistoren 28, 29 verbunden. Diese Transistoren 28, 29 bilden die dritte Verstärkerstufe 6. Die Basis von Transistor 29 ist mit der Basis von Transistor 28 verbunden, an der eine Referenzspannung 30 anliegt.

Die phasenschiebende Komponente 7 ist aus den beiden Widerständen 31, 33 und dem Kondensator 32 in gleicher Weise wie die phasenschiebende Komponente 5 aufgebaut. Die ersten Anschlüsse der Widerstände 31, 33 sind jeweils mit den Kollektoren der Transistoren 28, 29 verbunden, zwischen denen der Kondesnator 32 geschaltet ist. Die zweiten Anschlüsse der Widerstände 31, 33 sind mit einer dritten Eingangsklemme, an die eine Versorgungsspannung anlegbar ist, verbunden.

Die vierte Verstärkerstufe 9 wird aus einem Transistor 35 und einer Stromquelle 36 gebildet. Der Kollektor des Transistors 28 ist mit der Basis des weiteren Transistors 35 verbunden. Der Emitter des Transistors 35 ist zum einen mit der Anschlußklemme 2 und zum anderen mit dem ersten Anschluß der Stromquelle 36 verbunden. Der andere Anschluß der Stromquelle ist mit einem festen Potential, z.B. Masse, verbunden. Der Kollektor des Transistors 35 ist mit der dritten Eingangsklemme 34 verbunden.

An den Eingangsklemmen 22, 23 liegt die Steuerspannung für die Verstärkerstufe 4 an. Durch die Aufteilung des Stromes der Stromquelle 21 mittels der Transistoren 16 bis 20 und der anschließenden Summation wird erreicht, daß zum einen der Steuerstrom für den ersten Differenzverstärker, gebildet durch die Transistoren 40, 10 und zum anderen die Kollektorspannungen der Transistoren 12, 13, 28, 29 konstant bleiben. Auf diese Weise werden die Arbeitspunkte der Transistoren 12, 13, 28, 29 bei unterschiedlichen Steuerspannungen an den Transistoren 17, 19, 20 nicht verschoben. Durch die inverse Beschaltung der Eingänge des zweiten Differenzverstärkers 12, 13 wird das Ausgangssignal des zweiten Differenzverstärkers um 180° gegenüber dem Ausgangssignal des ersten Differenzverstärkers verschoben. Der Transistor 35 und die Stromquelle 36 bilden eine weitere Verstärkerstufe, die das an der zweiten phasenschiebenden Komponente 7 anliegende Signal auskoppelt. Die übrige Funktion entspricht der in FIG 1 beschriebenen. Die symmetrische Ausführung der Prinzipschaltungsanordnung in FIG 1 weist den Vorteil auf, daß Störgrößen durch die Gegentaktunterdrückung der einzelnen Verstärkerstufen kompensiert werden.

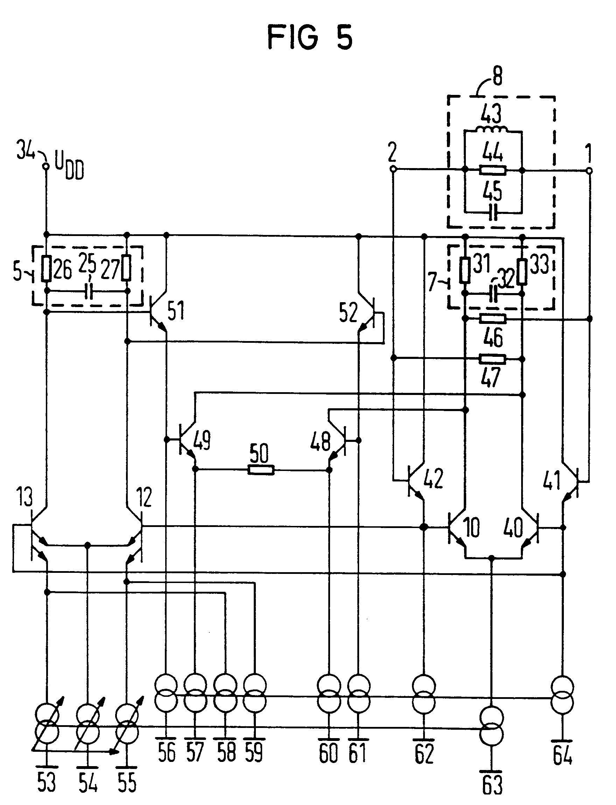

FIG 5 zeigt ein zweites Ausführungsbeispiel mit einem Parallelschwingkreis gemäß der Prinzipschaltungsanordnung in FIG 2. Der Parallelschwingkreis, der wiederum zwischen die beiden Eingangsklemmen 1, 2 geschaltet ist, besteht aus einer Induktivität 43, einem Widerstand 44 und einem Kondensator 45. Die erste Verstärkerstufe 3 wird wiederum durch einen Differenzverstärker gebildet. Dieser besteht aus den Transistoren 10, 40, 41, 42 und den Stromquellen 62, 63, 64. Die erste Eingangsklemme 1 ist mit der Basis des Transistors 41 und die zweite Eingangsklemme 2 mit der Basis des Transistors 42 verbunden. Die Kollektoren beider Transistoren 41, 42 sind mit der weiteren Anschlußklemme 34 verbunden, an die eine Versorgungsspannung anlegbar ist. Der Emitter vom Transistor 41 ist zum einen mit dem ersten Anschluß der Stromquelle 64 und zum anderen mit der Basis des Transistors 40 verbunden. Der Emitter des Transistors 42 ist zum einen mit dem ersten Anschluß der Stromquelle 62 und zum andern mit der Basis des Transistors 10 verbunden. Die Emitter der Transistoren 10, 40 sind mit dem ersten Anschluß der Stromquelle 62 verbunden. Die jeweils zweiten Anschlüsse der Stromquellen 62, 63, 64 sind mit einem festen Potential, z. B. Masse, verbunden. Der Kollektor von Transistor 10 ist über einen Widerstand 46 mit der ersten Eingangsklemme und der Kollektor von Transistor 40 über einen Widerstand 47 mit der zweiten Eingangsklemme verbunden.

Die zweite stromgesteuerte Verstärkerstufe 4 wird in gleicher Weise wie in FIG 4 durch einen Differenzverstärker, bestehend aus zwei Mehrfach-Emitter-Transistoren 12, 13, gebildet. Die Basis des Mehrfach-Emitter-Transistors 12 ist mit der Basis des Transistors 10 und die Basis des Mehrfach-Emitter-Transistors 13 ist mit der Basis von Transistor 40 verbunden. Die ersten Emitter der Mehrfach-Emitter-Transistoren 12, 13 sind mit dem ersten Anschluß einer variablen Stromquelle 54 verbunden. Die zweiten Emitter der Mehrfach-Emitter-Transistoren sind jeweils mit den ersten Anschlüssen zweier variabler Stromquellen 53, 55 verbunden. Den variablen Stromquellen 53, 55 ist jeweils eine Stromquelle 58, 59 parallel geschaltet. Die zweiten Anschlüsse der variablen Stromquellen 53, 54, 55 und der Stromquellen 58, 59 sind mit einem festen Potential, z. B. Masse verbunden.

Die phasenschiebende Komponente 5 ist in gleicher Weise wie in FIG 4 aufgebaut. Die ersten Anschlüsse der Widerstände 26, 27 sind jeweils mit den Kollektoren der Mehrfach-Emitter-Transistoren 12, 13 verbunden. Die zweiten Anschlüsse der Widerstände sind mit der Eingangsklemme 34 verbunden.

Die dritte Verstärkerstufe ist ebenfalls durch einen Differenzverstärker gebildet. Dieser besteht aus den Transistoren 48, 49, 51, 52, dem Widerstand 50 und den Stromquellen 56, 57, 60, 61. Die Kollektoren der Transistoren 51, 52 sind mit der Eingangsklemme 34 verbunden. Die Basisform von Transistor 51 ist mit dem Kollektor von Transistor 13 und die Basis von Transistor 52 mit dem Kollektor von Transistor 12 verbunden. Der Emitter von Transistor 51 ist zum einen mit der Basis von Transistor 49 und zum anderen mit dem ersten Anschluß der Stromquelle 56 verbunden. Der Emitter von Transistor 52 ist zum einen mit der Basis von Transistor 48 und zum anderen mit dem ersten Anschluß der Stromquelle 61 verbunden. Zwischen die Emitter der Transistoren 48, 49 ist der Widerstand 50 geschaltet. Der Emitter von Transistor 48 ist mit dem ersten Anschluß der Stromquelle 60 und der Emitter von Transistor 49 mit dem ersten Anschluß der Stromquelle 57 verbunden. Die zweiten Anschlüsse der Stromquellen 56, 57, 60, 61 sind wiederum mit einem festen Potential, z. B. Masse verbunden. Der Kollektor von Transistor 48 ist mit dem Kollektor von Transistor 10 und der Kollektor von Transistor 49 mit dem Kollektor von Transistor 40 verbunden.

Die phasenschiebende Komponente 7 ist in gleicher Weise wie in FIG 4 aufgebaut. Die ersten Anschlüsse der Widerstände 31, 33 sind jeweils mit den Kollektoren der Transistoren 10, 40 verbunden. Die zweiten Anschlüsse der Widerstände 31, 33 sind mit der Eingangsklemme 34 verbunden. Die variablen Stromquellen 53, 54, 55 und die Stromquelle 63 sind einer ersten Strombank und die Stromquellen 56...62, 64 sind einer zweiten Strombank zugeordnet.

Die Aufteilung des Stroms der variablen Stromquellen 53, 54, 55 kann wiederum wie in FIG 4 gezeigt durch eine Differenzstufe erfolgen. Die anschließende Summation in den Mehrfach-Emitter-Transistoren 12, 13 gewährleistet, daß die Kollektorspannungen dieser Transistoren konstant bleiben. Die symmetrische Ausführung gewährleistet wiederum ein geringes Übersprechen und Kompensation sonstiger äußerer Einflüsse. Die Funktionsweise entspricht der in FIG 1 oder 2 beschriebenen.

Die in FIG 5 dargestellte Schaltungsanordnung weist gegenüber der in FIG 4 gezeigten den Vorteil auf, daß auch bei kleiner Versorgungsspannung U_{DD} an der Eingangsklemme 34 eine ausreichende Kollektor-Emitterspannung der Transistoren der einzelnen Verstärkerstufen 3, 4, 6 gewährleistet ist. Bei kleiner Versorgungsspannung wird dies in der in FIG 4 gezeigten Schaltungsanordnung durch die an den Transistoren der Verstärkerstufen 3, 4, 6, 9 entstehenden Spannungsabfälle nicht der Fall sein.

Die in den Figuren 4 und 5 verwendeten NPN-Transistoren können sowohl durch PNP-Transistoren als auch durch P- oder N-Kanal-FET's ersetzt werden.

## Patentansprüche

1. Integrierbare frequenzvariable Oszillatorschaltung mit einer rückgekoppelten Verstärkeranordnung mit den Merkmalen:
a) ein frequenzbestimmendes Rückkopplungsglied (8) ist zwischen zwei Eingangsklemmen (1, 2) geschaltet,
b) die erste Eingangsklemme (1) ist mit je einem Eingang zweier Verstärkerstufen (3, 4) verbunden,
c) die Verstärkerstufen (3, 4) erzeugen jeweils Ausgangssignale,
d) die Verstärkung der zweiten Verstärkerstufe (4) ist veränderbar,
e) das Ausgangssignal der zweiten Verstärkerstufe (4) wird einer phasenschiebenden Komponente (5) zugeführt,
f) das Ausgangssignal der ersten Verstärkerstufe (3) und das Ausgangssignal der zweiten Verstärkerstufe (4) werden nach der phasenschiebenden Komponente (5) aufaddiert und
g) über eine weitere phasenschiebende Komponente (7) der zweiten Eingangsklemme (2) zugeführt,
**dadurch gekennzeichnet, daß**
h) das Ausgangssignal der phasenschiebenden Komponente (5) über eine dritte Verstärkerstufe (6) geführt wird,
i) die zweite Verstärkerstufe (4) mindestens zwei Mehrfach-Emitter-Transistoren (12, 13) umfaßt,
j) von denen jeweils ein erster Teil der Emitter miteinander gekoppelt ist und von einem Strom einer ersten Stromstärke (17, 21; 54) gespeist wird,
k) von denen jeweils ein zweiter Teil der Emitter von einem Strom einer zweiten Stromstärke (19, 20, 21; 53, 58, 55, 59) gespeist wird,
l) und daß die Verstärkung durch den Unterschied zwischen den ersten und zweiten Stromstärken veränderbar ist.

2. Oszillatorschaltung nach Anspruch 1,
**dadurch gekennzeichnet**, daß die ersten, zweiten und dritten Verstärkerstufen (3, 4, 6) in Bezug auf ihre Strompfade parallel geschaltet sind und an einem ihrer Verbindungspunkte aus einer einzigen Stromquelle (21) gespeist werden.

3. Oszillatorschaltung nach Anspruch 1,
**dadurch gekennzeichnet**, daß die Emitter der Mehrfach-Emitter-Transistoren (12, 13) mit einer veränderbaren Stromquelle (53, 54, 55) verbunden sind und daß die Emitter des zweiten Teils der Emitter jeweils mit einer Konstantstromquelle (58, 59) verbunden sind.

4. Oszillatorschaltung nach einem der Ansprüche 1 bis 2,
**dadurch gekennzeichnet**, daß das Ausgangssignal der ersten Verstärkerstufe (3) dem Eingang der dritten Verstärkerstufe (6) zugeführt wird.

5. Oszillatorschaltung Anspruch 3,
**dadurch gekennzeichnet,** daß das Ausgangssignal der ersten Verstärkerstufe (3) zwischen dem Ausgang der dritten Verstärkerstufe (6) und der weiteren phasenschiebenden Komponente (7) dem Ausgangssignal der dritten Verstärkerstufe (6) aufaddiert wird.

6. Oszillatorschaltung nach einem der Ansprüche 1 bis 3,
**dadurch gekennzeichnet**, daß zwischen dem Ausgang der dritten Verstärkerstufe (6) und der zweiten Eingangsklemme (2) eine vierte Verstärkerstufe (9) derart geschaltet ist, daß das Ausgangssignal der dritten Verstärkerstufe (6) dem Eingang der vierten Verstärkerstufe (9) zugeführt wird und der Ausgang der vierten Verstärkerstufe (9) mit der zweiten Eingangsklemme (2) verbunden ist.

7. Oszillatorschaltung nach einem der Ansprüche 1 bis 3,
**dadurch gekennzeichnet,** daß die phasenschiebende Komponente (5) die Phase des Ausgangssignals der zweiten Verstärkerstufe (4) um +225° verschiebt.

8. Oszillatorschaltung nach einem der Ansprüche 1 bis 3,
**dadurch gekennzeichnet**, daß die zweite Verstarkerstufe (4) das an ihrem Eingang anliegende Signal invertiert und daß die phasenschiebende Komponente (5) die Phase des Ausgangssignals der zweiten Verstärkerstufe (4) um +45° verschiebt.

9. Oszillatorschaltung nach einem der Ansprüche 1 bis 3,
**dadurch gekennzeichnet**, daß die weitere phasenschiebende Komponente (7) eine Phasenverschiebung von +45° bewirkt.

10. Oszillatorschaltung nach einem der Ansprüche 8 oder 9,
**dadurch gekennzeichnet**, daß die phasenschiebende Komponente (5, 7) ein Tiefpaß ist.

## Claims

1. Integrable variable-frequency oscillator circuit with a feedback amplifier arrangement, having the features:
a) a frequency-determining feedback element (8) is connected between two input terminals (1, 2),
b) the first input terminal (1) is connected to in each case one input of two amplifier stages (3, 4),
c) the amplifier stages (3, 4) each generate output signals,
d) the gain of the second amplifier stage (4) is variable,
e) the output signal of the second amplifier stage (4) is fed to a phase-shifting component (5),
f) the output signal of the first amplifier stage (3) and the output signal of the second amplifier stage (4) are added downstream of the phase-shifting component (5) and
g) fed to the second input terminal (2) via a further phase-shifting component (7),
characterized in that
h) the output signal of the phase-shifting component (5) is passed via a third amplifier stage (6),
i) the second amplifier stage (4) comprises at least two multiple-emitter transistors (12, 13),
j) of which a first group of emitters are in each case coupled to one another and fed by a current of a first current intensity (17, 21; 54),
k) of which a second group of emitters are in each case fed by a current of a second current intensity (19, 20, 21; 53, 58, 55, 59),
l) and in that the gain can be varied by the difference between the first and second current intensities.

2. Oscillator circuit according to Claim 1, characterized in that the first, second and third amplifier stages (3, 4, 6) are connected with their current paths in parallel and are fed at one of their junction points from a single current source (21).

3. Oscillator circuit according to Claim 1, characterized in that the emitters of the mulitple-emitter transistors (12, 13) are connected to a variable current source (53, 54, 55), and in that the emitters of the second group of emitters are each connected to a constant-current source (58, 59).

4. Oscillator circuit according to one of Claims 1 and 2, characterized in that the output signal of the first amplifier stage (3) is fed to the input of the third amplifier stage (6).

5. Oscillator circuit according to Claim 3, characterized in that the output signal of the first amplifier stage (3) is added to the output signal of the third amplifier stage (6), between the output of the third amplifier stage (6) and the further phase-shifting component (7).

6. Oscillator circuit according to one of Claims 1 to 3, characterized in that a fourth amplifier stage (9) is connected between the output of the third amplifier stage (6) and the second input terminal (2) in such a way that the output signal of the third amplifier stage (6) is fed to the input of the fourth amplifier stage (9) and the output of the fourth amplifier stage (9) is connected to the second input terminal (2).

7. Oscillator circuit according to one of Claims 1 to 3, characterized in that the phase-shifting component (5) shifts the phase of the output signal of the second amplifier stage (4) by +225°.

8. Oscillator circuit according to one of Claims 1 to 3, characterized in that the second amplifier stage (4) inverts the signal which is present at its input, and in that the phase-shifting components (5) shifts the phase of the output signal of the second amplifier stage (4) by +45°.

9. Oscillator circuit according to one of Claims 1 to 3, characterized in that the further phase-shifting component (7) produces a phase shift of +45°.

10. Oscillator circuit according to one of Claims 8 and 9, characterized in that the phase-shifting component (5, 7) is a low-pass filter.

## Revendications

1. Circuit oscillateur pouvant être intégré, à fréquence variable, comportant un dispositif amplificateur à rétroaction et ayant les particularités suivantes :
a) un élément (8) de rétroaction déterminant une fréquence est branché entre deux bornes (1, 2) d'entrée,
b) la première borne (1) d'entrée est reliée à chaque entrée de deux étages (3, 4) amplificateurs,
c) les étages (3, 4) amplificateurs produisent chacun des signaux de sortie,
d) le gain du deuxième étage (4) amplificateur peut être modifié,
e) le signal de sortie du deuxième étage (4) amplificateur est envoyé à un composant (5) décalant la phase,
f) le signal de sortie du premier étage (3) amplificateur et le signal de sortie du deuxième étage (4) amplificateur sont additionnés en aval du composant (5) décalant la phase et
g) sont envoyés par l'intermédiaire d'un autre composant (7) décalant la phase à la deuxième borne (2) d'entrée,
caractérisé en ce que
h) le signal de sortie du composant (5) décalant la phase est envoyé par l'intermédiaire d'un troisième étage (6) amplificateur,
i) le deuxième étage (4) amplificateur comprend au moins deux transistors (12, 13) à émetteurs multiples,
j) dont une première partie des émetteurs est reliée réciproquement et est alimentée par un courant d'une première intensité (17, 21 ; 54),
k) et dont une deuxième partie des émetteurs est alimentée par un courant d'une deuxième intensité (19, 20, 21 ; 53, 58, 55, 59),
l) et le gain peut être modifié par la différence entre les première et deuxième intensités.

2. Circuit oscillateur suivant la revendication 1,
caractérisé en ce que les chemins de courant des premiers, deuxièmes et troisièmes étages (3, 4, 6) amplificateurs sont branchés en parallèle et sont alimentés, en l'un de leurs points de liaison, par une unique source (21) de courant.

3. Circuit oscillateur suivant la revendication 1,
caractérisé en ce que les émetteurs des transistors (12, 13) à émetteurs multiples sont reliés à une source (53, 54, 55) de courant pouvant être modifiée et les émetteurs de la deuxième partie des émetteurs sont reliés chacun à une source (58, 59) de courant constant.

4. Circuit oscillateur suivant l'une des revendications 1 à 2,
caractérisé en ce que le signal de sortie du premier étage (3) amplificateur est envoyé à l'entrée du troisième étage (6) amplificateur.

5. Circuit oscillateur suivant la revendication 3,
caractérisé en ce que le signal de sortie du premier étage (3) amplificateur est additionné entre la sortie du troisième étage (6) amplificateur et l'autre composant (7) décalant la phase au signal de sortie du troisième étage (6) amplificateur.

6. Circuit oscillateur suivant l'une des revendications 1 à 3,
caractérisé en ce qu'un quatrième étage (9) amplificateur est branché entre la sortie du troisième étage (6) amplificateur et la deuxième borne (2) d'entrée, de telle sorte que le signal de sortie du troisième étage (6) amplificateur soit envoyé à l'entrée du quatrième étage (9) amplificateur et que la sortie du quatrième étage (9) amplificateur soit relié à la deuxième borne (2) d'entrée.

7. Circuit oscillateur suivant l'une des revendications 1 à 3,
caractérisé en ce que le composant (5) décalant la phase décale la phase du signal de sortie du deuxième étage (4) amplificateur, de + 225°.

8. Circuit oscillateur suivant l'une des revendications 1 à 3,
caractérisé en ce que le deuxième étage (4) amplificateur inverse le signal appliqué à son entrée et le composant (5) décalant la phase décale la phase du signal de sortie du deuxième étage (4) amplificateur de + 45°.

9. Circuit oscillateur suivant l'une des revendications 1 à 3,
caractérisé en ce que l'autre composant (7) décalant la phase provoque un décalage de phases de + 45°.

10. Circuit oscillateur suivant l'une des revendications 8 ou 9, caractérisé en ce que le composant (5, 7) décalant la phase est un passe-bas.
